# EUROPEAN PATENT APPLICATION

(11) **EP 4 848 926 A1**
(43) Date of publication of application: **02.12.2026**
(21) Application number: 25221326.9
(22) Date of filing: 08.12.2025
(51) Int. Cl.: H10B 41/27, H10B 41/35, H10B 43/27, H10B 43/35

(54) **SEMICONDUCTOR DEVICE AND METHOD OF MANUFACTURING SEMICONDUCTOR DEVICE**

(30) Priority: 28.05.2025 KR 20250069410
(71) Applicant: SK hynix Inc., Bubal-eub Icheon-si Gyeonggi-do 17336 (KR)
(72) Inventor: LEE, Dong Ik, 17336 Icheon-si, Gyeonggi-do (KR)
(74) Representative: Isarpatent

(57) **Abstract**

A semiconductor device is provided. The semiconductor device includes: a gate structure including alternately stacked conductive layers and insulating layers; a source layer disposed to face a surface of the gate structure; a channel structure extending through the gate structure and including a first portion and a second portion, the first portion having a first width, the second portion having a second width greater than the first width; and an epitaxial pattern disposed between at least a portion of the channel structure and the source layer and connected to the second portion of the channel structure.

## Description

### BACKGROUND

### 1. Technical Field

Embodiments of the present disclosure relate to an electronic device, and more particularly, to a semiconductor device and a method of manufacturing the semiconductor device.

### 2. Related Art

The degree of integration of a semiconductor device is mainly determined by an area occupied by a unit memory cell. Recently, as the improvement in the degree of integration of semiconductor devices for forming memory cells in a single layer on a substrate reaches a limit, three-dimensional semiconductor devices for stacking memory cells on a substrate have been proposed. Furthermore, in order to improve the operational reliability of such semiconductor devices, various structures and manufacturing methods have been developed.

### SUMMARY

In an embodiment, a semiconductor device may include: a gate structure including alternately stacked conductive layers and insulating layers; a source layer disposed to face a surface of the gate structure; a channel structure extending through the gate structure and including a first portion and a second portion, the first portion having a first width, the second portion having a second width greater than the first width; and an epitaxial pattern disposed between at least a portion of the channel structure and the source layer and connected to the second portion of the channel structure.

In an embodiment, a semiconductor device may include: a gate structure including alternately stacked conductive layers and insulating layers; a source layer disposed over the gate structure; an insulating core, including a first region and a second region, the first region having a first width, the second region having a second width greater than the first width, extending through the gate structure; a memory layer surrounding the insulating core; a channel layer including a body portion and a protrusion portion, the body portion disposed between the insulating core and the memory layer, the protrusion portion penetrating through the memory layer and connected to the source layer; and an epitaxial pattern disposed between the source layer and the memory layer and surrounding sidewalls of the protrusion portion.

In an embodiment, a method of manufacturing a semiconductor device may include: forming a stack on a substrate, the stack including alternately stacked first material layers and second material layers; forming a first opening extending through the stack and exposing the substrate; growing an epitaxial pattern from the substrate exposed through the first opening; forming a barrier pattern in the first opening; etching the epitaxial pattern using the barrier pattern as an etching barrier; and etching the stack exposed between the barrier pattern and the epitaxial pattern to form a second opening.

In an embodiment, a method of manufacturing a semiconductor device may include: forming a stack on a substrate, the stack including alternately stacked first material layers and second material layers; forming a first opening extending through the stack and exposing the substrate; forming a sacrificial pattern in a lower portion of the first opening; forming a barrier pattern on an inner wall of the first opening exposed through the sacrificial pattern; etching the sacrificial pattern using the barrier pattern as an etching barrier; forming a second opening by etching the stack exposed between the barrier pattern and the sacrificial pattern, the second opening having a greater width at a lower portion thereof than that at an upper portion thereof; forming a preliminary channel layer, having a first thickness, in the second opening; and forming a channel layer, having a second thickness less than the first thickness, by etching the preliminary channel layer.

### BRIEF DESCRIPTION OF THE DRAWINGS

FIGS. 1A and 1B are diagrams illustrating the structure of a semiconductor device in accordance with an embodiment of the present disclosure.
FIGS. 2A to 2C are diagrams illustrating the structure of a semiconductor device in accordance with an embodiment of the present disclosure.
FIG. 3 is a diagram illustrating the structure of a semiconductor device in accordance with an embodiment of the present disclosure.
FIG. 4 is a diagram illustrating the structure of a semiconductor device in accordance with an embodiment of the present disclosure.
FIGS. 5A to 5F are diagrams for describing a method of a manufacturing semiconductor device in accordance with an embodiment of the present disclosure.
FIGS. 6A to 6H are diagrams for describing a method of manufacturing a semiconductor device in accordance with an embodiment of the present disclosure.
FIG. 7 is a configuration diagram of a semiconductor device in accordance with an embodiment of the present disclosure.
FIG. 8 is a configuration diagram of a semiconductor device in accordance with an embodiment of the present disclosure.

### DETAILED DESCRIPTION

Various embodiments are directed to a semiconductor device having a stable structure and improved characteristics and a method of manufacturing the semiconductor device.

By stacking memory cells in three dimensions, the embodiments enable improvement in the degree of integration of a semiconductor device. The embodiments may also provide a semiconductor device having a stable structure and improved reliability.

Hereafter, embodiments in accordance with the technical spirit of the present disclosure will be described with reference to the accompanying drawings.

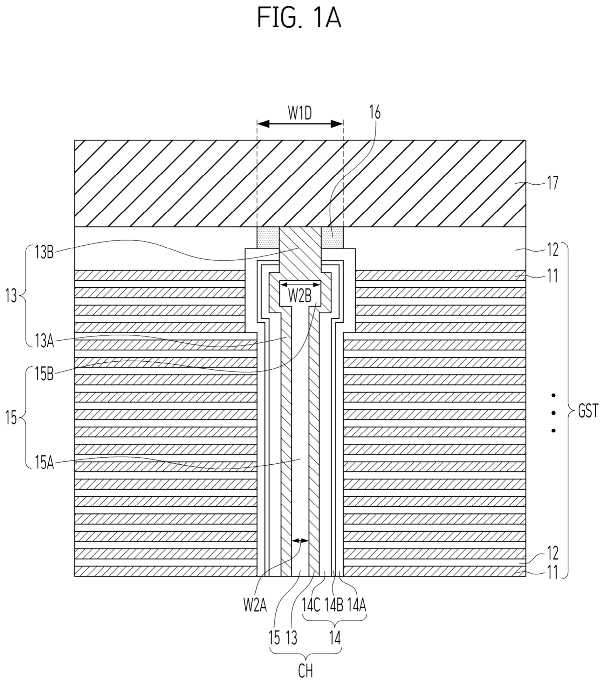

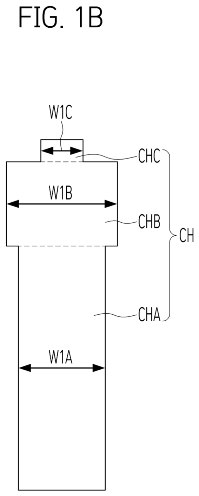

FIGS. 1A and 1B are diagrams illustrating the structure of a semiconductor device in accordance with an embodiment of the present disclosure.

Referring to FIGS. 1A and 1B, a semiconductor device may include a gate structure GST, a source layer 17, a channel structure CH, and an epitaxial pattern 16. The gate structure GST may include conductive layers 11 and insulating layers 12 that are alternately stacked. The conductive layers 11 may be gate lines such as a source select line, word lines, or a drain select line. The conductive layers 11 may include at least one drain select line, word lines stacked on at least one drain select line, and at least one source select line stacked on the word lines. The conductive layers 11 may each include a conductive material such as polysilicon, tungsten (W), or molybdenum (Mo). The insulating layers 12 may each include an insulating material such as oxide, nitride, or air gap.

The source layer 17 may be disposed to face a surface of the gate structure GST. The source layer 17 may be disposed over the gate structure GST or disposed under the gate structure GST. The source layer 17 may include a conductive material such as polysilicon or metal. The source layer 17 may have a single-layer or multilayer structure. The uppermost insulating layer in contact with the source layer 17 among the insulating layers 12 included in the gate structure GST may have a greater thickness than each of the remaining insulating layers.

The channel structure CH may extend through the gate structure GST. As an example, the channel structure CH may extend in a vertical direction, and may be connected to the source layer 17. The channel structure CH may include a first portion CHA having a first width W1A and a second portion CHB having a second width W1B greater than the first width W1A. The second portion CHB may be disposed closer to the source layer 17 than the first portion CHA is.

The channel structure CH may further include a third portion CHC having a third width W1C less than the second width W1B. The second portion CHB may be disposed between the first portion CHA and the third portion CHC, and the third portion CHC may be connected to the source layer 17. The third width W1C may be less than the first width W1A.

The second portion CHB of the channel structure CH may be disposed to correspond to the source select line, and the first portion CHA of the channel structure CH may be disposed to correspond to the drain select line and the word lines. However, the present disclosure is not limited thereto, and the second portion CHB of the channel structure CH may be disposed to correspond to the word line or the drain select line.

The channel structure CH may include a channel layer 13, and may further include a memory layer 14 and/or an insulating core 15. The memory layer 14 may include at least one of a blocking layer 14A, a data storage layer 14B, and a tunneling layer 14C. The data storage layer 14B may include a floating gate, polysilicon, a charge trap material, nitride, a variable resistance material, or the like.

The insulating core 15 may extend through the gate structure GST, and may be disposed inside the gate structure GST. An upper surface of the insulating core 15 may be disposed at a lower level than an upper surface of the uppermost insulating layer 12. The insulating core 15 may include a first region 15A having a first width W2A and a second region 15B having a second width W2B greater than the first width W2A. The first region 15A and the second region 15B of the insulating core 15 may be disposed to correspond to the first portion CHA and the second portion CHB of the channel structure CH, respectively.

The channel layer 13 may surround the insulating core 15, and the memory layer 14 may surround the channel layer 13. The memory layer 14 may surround the insulating core 15, and the channel layer 13 may be disposed between the insulating core 15 and the memory layer 14. An upper surface of the memory layer 14 may be disposed at a lower level than an upper surface of the channel layer 13. The upper surface of the memory layer 14 may be disposed at a higher level than an upper surface of the uppermost conductive layer 11.

The channel layer 13 may include a body portion 13A and a protrusion portion 13B. The body portion 13A may surround the insulating core 15, and may be disposed between the insulating core 15 and the memory layer 14. The protrusion portion 13B may protrude from the body portion 13A, and may penetrate through the memory layer 14 and be connected to the source layer 17.

The epitaxial pattern 16 may be a silicon layer grown in an epitaxial manner. The epitaxial pattern 16 may be disposed between the channel structure CH and the source layer 17, and may be connected to the second portion CHB of the channel structure CH. The epitaxial pattern 16 may surround the third portion CHC of the channel structure CH. The epitaxial pattern 16 may have a spacer shape surrounding sidewalls of the third portion CHC. The epitaxial pattern 16 may surround sidewalls of the protrusion portion 13B of the channel layer 13. The protrusion portion 13B may penetrate through the epitaxial pattern 16 and be directly connected to the source layer 17. The epitaxial pattern 16 may have a fourth width W1D less than the second width W1B. The fourth width W1D may be greater than the third width W1C.

An upper surface of the epitaxial pattern 16 may be disposed on the same plane as the upper surface of the channel layer 13. The upper surface of the epitaxial pattern 16 may be disposed on the same plane as an upper surface of the protrusion portion 13B. A lower surface of the epitaxial pattern 16 may be disposed at a higher level than the upper surface of the uppermost conductive layer 11.

According to the structure described above, the channel structure CH may include the second portion CHB having a relatively great width, and the epitaxial pattern 16 may be disposed between the channel structure CH and the source layer 17. The channel layer 13 may be directly connected to the source layer 17 or be connected to the source layer 17 through the epitaxial pattern 16. Because a width of an opening is partially expanded by using the epitaxial pattern 16 in a manufacturing process, the channel layer 13 may have a great grain size. Accordingly, a cell current of the semiconductor device may be improved.

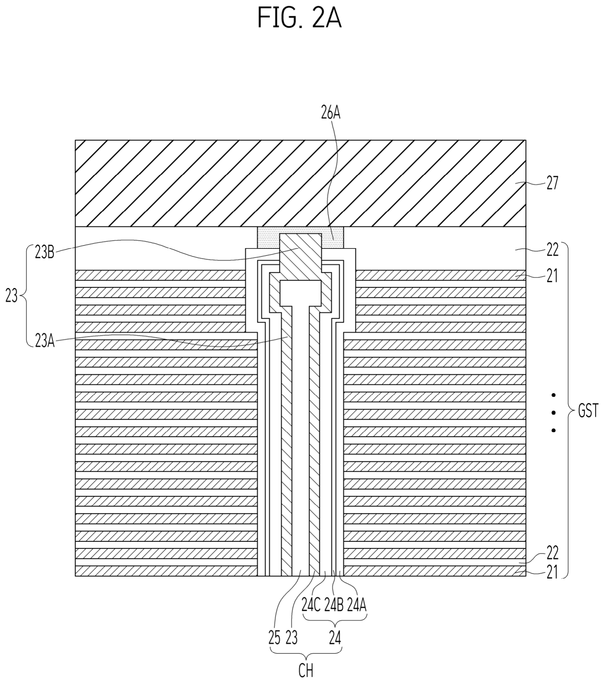

FIGS. 2A to 2C are diagrams illustrating the structure of a semiconductor device in accordance with an embodiment of the present disclosure. Hereinafter, content overlapping with previously described content may be omitted.

Referring to FIG. 2A, the semiconductor device may include a gate structure GST, a source layer 27, a channel structure CH, and an epitaxial pattern 26A. The gate structure GST may include conductive layers 21 and insulating layers 22 that are alternately stacked. The source layer 27 may be disposed over the gate structure GST. The channel structure CH may extend through the gate structure GST, and may be connected to the source layer 27. The channel structure CH may include a channel layer 23, a memory layer 24, and an insulating core 25. The memory layer 24 may include a blocking layer 24A, a data storage layer 24B, and a tunneling layer 24C.

The channel layer 23 may include a body portion 23A surrounding the insulating core 25 and a protrusion portion 23B penetrating through the memory layer 24. The epitaxial pattern 26A may be disposed between the channel structure CH and the source layer 27, and may surround the protrusion portion 23B. As an example, the epitaxial pattern 26A may surround an upper surface of the protrusion portion 23B, and may have a U-shaped cross section. The channel layer 23 may be connected to the source layer 27 through the epitaxial pattern 26A.

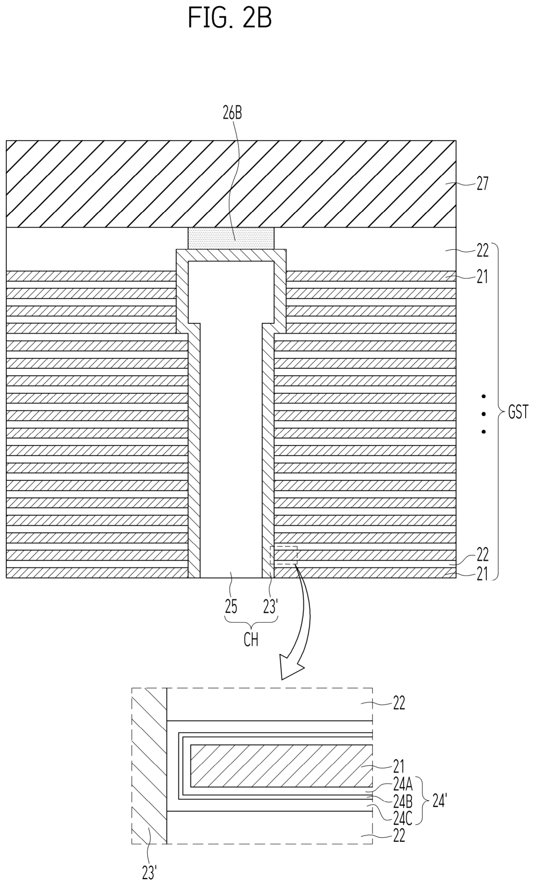

Referring to FIG. 2B, the semiconductor device may include a gate structure GST, a source layer 27, a channel structure CH, and an epitaxial pattern 26B. The source layer 27 may be disposed over the gate structure GST. The channel structure CH may extend through the gate structure GST. The channel structure CH may include a channel layer 23' and an insulating core 25. A memory layer 24' may surround the conductive layer 21, and may have a C-shaped cross section.

Unlike the channel layer 23 described above with reference to FIG. 2A, the channel layer 23' might not include a protrusion portion, and the channel structure CH may have a flat upper surface. The epitaxial pattern 26B may be in contact with the flat upper surface of the channel structure CH, and the channel layer 23' may be connected to the source layer 27 through the epitaxial pattern 26B.

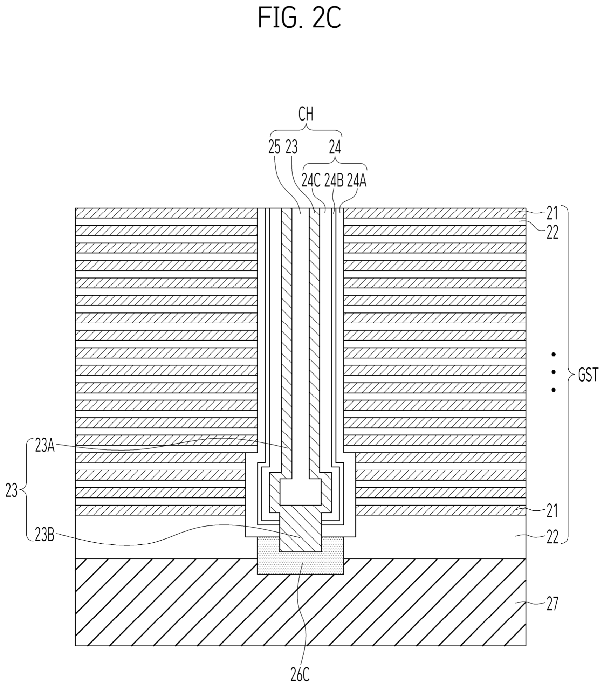

Referring to FIG. 2C, the semiconductor device may include a gate structure GST, a source layer 27, a channel structure CH, and an epitaxial pattern 26C. The source layer 27 may be disposed under the gate structure GST. The channel structure CH may extend through the gate structure GST. The channel structure CH may include a channel layer 23, a memory layer 24, and an insulating core 25.

The channel layer 23 may include a body portion 23A surrounding the insulating core 25 and a protrusion portion 23B penetrating through the memory layer 24. The epitaxial pattern 26C may be disposed between the channel structure CH and the source layer 27, and may surround the protrusion portion 23B. As an example, the epitaxial pattern 26C may surround a lower surface of the protrusion portion 23B, and may have a U-shaped cross section. The channel layer 23 may be connected to the source layer 27 through the epitaxial pattern 26C.

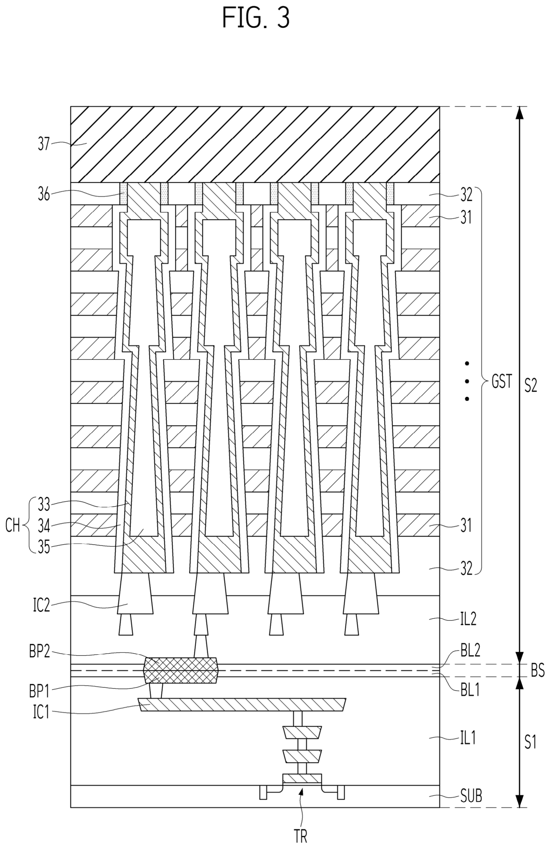

FIG. 3 is a diagram illustrating the structure of a semiconductor device in accordance with an embodiment of the present disclosure. Hereinafter, content overlapping with previously described content may be omitted.

Referring to FIG. 3, the semiconductor device may include a first semiconductor structure S1, a second semiconductor structure S2, and a bonding structure BS. The first semiconductor structure S1 may include a peripheral circuit, and the second semiconductor structure S2 may include a memory cell array.

The first semiconductor structure S1 may include a substrate SUB, a transistor TR, a first interlayer insulating layer IL1, and a first interconnection structure IC1. The transistor TR may belong to the peripheral circuit. The peripheral circuit may include a row decoder, a page buffer, an input and output (input/output) circuit, a logic circuit, and the like. The first interconnection structure IC1 may be disposed in the first interlayer insulating layer IL1, and may include a via, a wiring line, and the like. The first interconnection structure IC1 may be electrically connected to the peripheral circuit.

The second semiconductor structure S2 may include a source layer 37, a gate structure GST, a channel structure CH, an epitaxial pattern 36, a second interlayer insulating layer IL2, and a second interconnection structure IC2. The gate structure GST may include conductive layers 31 and insulating layers 32 that are alternately stacked. The source layer 37 may be disposed over the gate structure GST. The channel structure CH may include a channel layer 33, and may further include a memory layer 34 and/or an insulating core 35. The epitaxial pattern 36 may be disposed between the channel structure CH and the source layer 37. The channel structure CH and the epitaxial pattern 36 may have the shapes described above with reference to FIGS. 1A, 1B, and 2A to 2C.

The second interconnection structure IC2 may be disposed in the second interlayer insulating layer IL2, and may be electrically connected to the memory cell array. The second interconnection structure IC2 may include a via, a wiring line, and the like.

The bonding structure BS may be disposed between the first semiconductor structure S1 and the second semiconductor structure S2. The first semiconductor structure S1 and the second semiconductor structure S2 may be manufactured separately, and may be electrically connected to each other by the bonding structure BS. For reference, some of components of the second semiconductor structure S2 may be formed after the first semiconductor structure S1 and the second semiconductor structure S2 are bonded to each other. The peripheral circuit, and the memory cell array including the gate structure GST and the channel structure CH may be electrically connected to each other through the bonding structure BS.

The bonding structure BS may include a first bonding layer BL1, a second bonding layer BL2, a first bonding pad BP1, and a second bonding pad BP2. The first bonding layer BL1 and the second bonding layer BL2 may be bonded to each other, and the first bonding pad BP1 and the second bonding pad BP2 may be electrically connected to each other. The first bonding layer BL1 and the second bonding layer BL2 may each include silicon carbon nitride (SiCN), tetraethyl orthosilicate (TEOS), or the like. The first bonding pad BP1 may be electrically connected to the first interconnection structure IC1, and the second bonding pad BP2 may be electrically connected to the second interconnection structure IC2. The memory cell array and the peripheral circuit may be electrically connected to each other through the first bonding pad BP1 and the second bonding pad BP2.

According to the structure described above, the first semiconductor structure S1 and the second semiconductor structure S2 are bonded to each other in a vertical direction, and the embodiment may thereby increase the degree of integration of the semiconductor device. Because the channel structure CH has an expanded width at a portion thereof, a cell current may be improved, and operation characteristics of the semiconductor device may be improved.

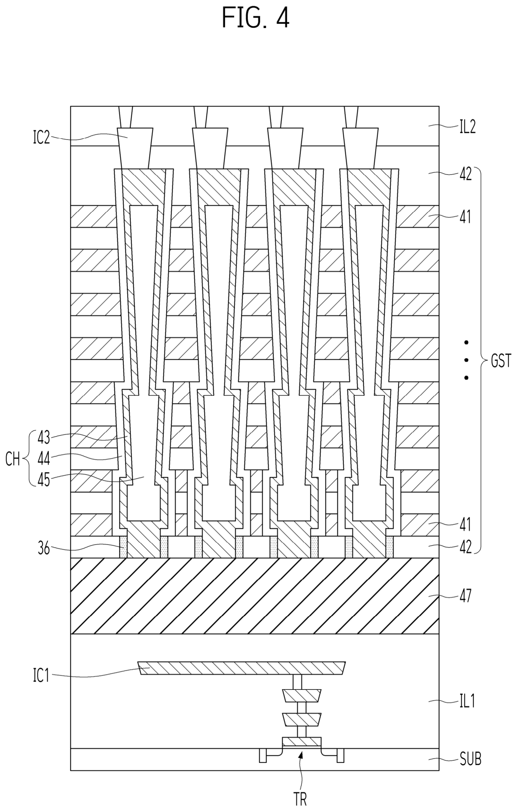

FIG. 4 is a diagram illustrating the structure of a semiconductor device in accordance with an embodiment of the present disclosure. Hereinafter, content overlapping with previously described content may be omitted.

Referring to FIG. 4, the semiconductor device may include a substrate SUB, a transistor TR, a first interconnection structure IC1, a first interlayer insulating layer IL1, a source layer 47, a gate structure GST, a channel structure CH, an epitaxial pattern 46, a second interconnection structure IC2, and a second interlayer insulating layer IL2. A peripheral circuit may be disposed under a memory cell array.

The transistor TR may be disposed on the substrate SUB, and may belong to the peripheral circuit. The first interconnection structure IC1 may be formed in the first interlayer insulating layer IL1, and may be electrically connected to the peripheral circuit. The first interconnection structure IC1 may include a via, a wiring line, and the like.

The gate structure GST may be disposed on the first interlayer insulating layer IL1. The gate structure GST may include conductive layers 41 and insulating layers 42 that are alternately stacked. The source layer 47 may be disposed under the gate structure GST. The channel structure CH may include a channel layer 43, and may further include a memory layer 44 and/or an insulating core 45. The epitaxial pattern 46 may be disposed between the channel structure CH and the source layer 47. The channel structure CH and the epitaxial pattern 46 may have the shapes described above with reference to FIGS. 1A, 1B, and 2A to 2C.

The second interlayer insulating layer IL2 may be disposed over the gate structure GST. The second interconnection structure IC2 may be disposed in the second interlayer insulating layer IL2, and may be connected to the channel structure CH or the like. The second interconnection structure IC2 may include a via, a wiring line, and the like.

According to the structure described above, by disposing the peripheral circuit under the memory cell array, the embodiments may increase the degree of integration of the semiconductor device. Because the channel structure CH has an expanded width at a portion thereof, a cell current may be improved, and operation characteristics of the semiconductor device may be improved.

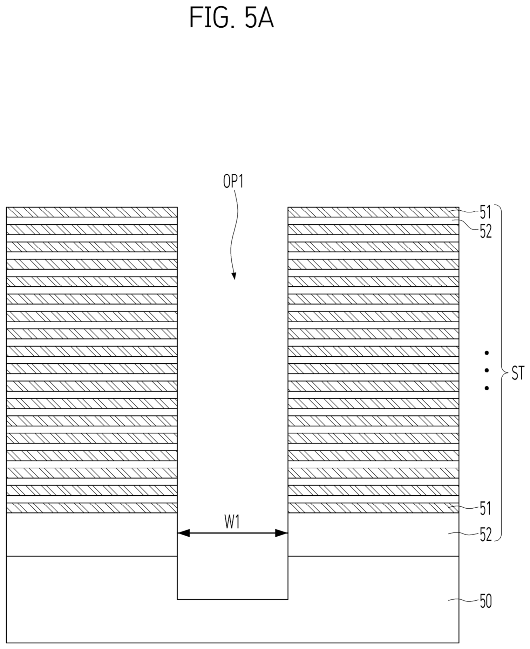

FIGS. 5A to 5F are diagrams for describing a method of a manufacturing semiconductor device in accordance with an embodiment of the present disclosure. Hereinafter, content overlapping with previously described content may be omitted.

Referring to FIG. 5A, a stack ST including first material layers 51 and second material layers 52 that are alternately stacked may be formed on a substrate 50. The first material layers 51 may be used to form gate lines, and the second material layers 52 may be used to insulate the stacked gate lines from each other. The lowermost second material layer of the second material layers 52 may have a greater thickness than the remaining second material layers.

Subsequently, a first opening OP1 extending through the stack ST and exposing the substrate 50 may be formed. The first opening OP1 may expose a surface of the substrate 50 or may extend into the substrate 50. The first opening OP1 may be a channel hole for forming a channel structure. The first opening OP1 may have a uniform width along a vertical direction, or may have different widths at different vertical levels (e.g., top, middle, or bottom). As an example, the first opening OP1 may have a first width W1. The first width W1 of the first opening OP1 may refer to an average width of the first opening OP1 measured across its depth. Alternately, the first width W1 may refer to a lower width, which corresponds to the width of the first opening OP1 at a bottom portion thereof.

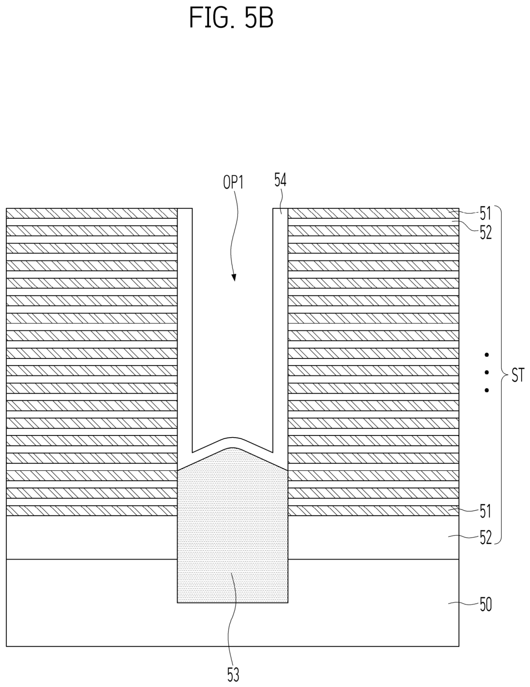

Referring to FIG. 5B, a sacrificial pattern 53 filling a lower portion of the first opening OP1 and opening an upper portion of the first opening OP1 may be formed in the first opening OP1. As an example, the sacrificial pattern 53 may be formed by growing an epitaxial pattern from the substrate 50 exposed through the first opening OP1. A silicon layer may be grown by an epitaxial growth method, and may be grown in the vertical direction to fill the lower portion of the first opening OP1. As an example, a sacrificial layer may be formed to fill the first opening OP1, and the sacrificial pattern 53 filling the lower portion of the first opening OP1 may be formed by etching back the sacrificial layer.

Depending on a height at which the sacrificial pattern 53 is formed, an increase range of a width of the first opening OP1 may be determined in a subsequent process. As an example, the sacrificial pattern 53 may be formed at a height at which it covers the first material layers 51 corresponding to source select lines.

Subsequently, a barrier layer 54 may be formed in the first opening OP1. The barrier layer 54 is used to cover a portion of the first opening OP1 whose width is not expanded in the subsequent process. The barrier layer 54 may be formed along surfaces of the stack ST and the sacrificial pattern 53 exposed through the first opening OP1. The barrier layer 54 may include a material having a high etching selectivity with respect to the sacrificial pattern 53 and the stack ST. As an example, the barrier layer 54 may include metal nitride such as TiN.

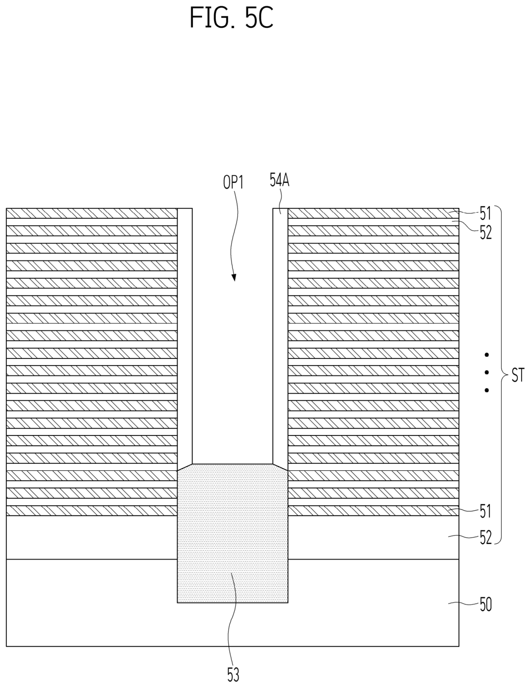

Referring to FIG. 5C, a barrier pattern 54A may be formed in the first opening OP1 by etching the barrier layer 54. An etch-back process may be used, and a portion of the barrier layer 54 formed on the surface of the sacrificial pattern 53 may be etched. Through this, the barrier pattern 54A exposing an upper surface of the sacrificial pattern 53 may be formed. For reference, the sacrificial pattern 53 may be partially etched in a process of etching the barrier layer 54.

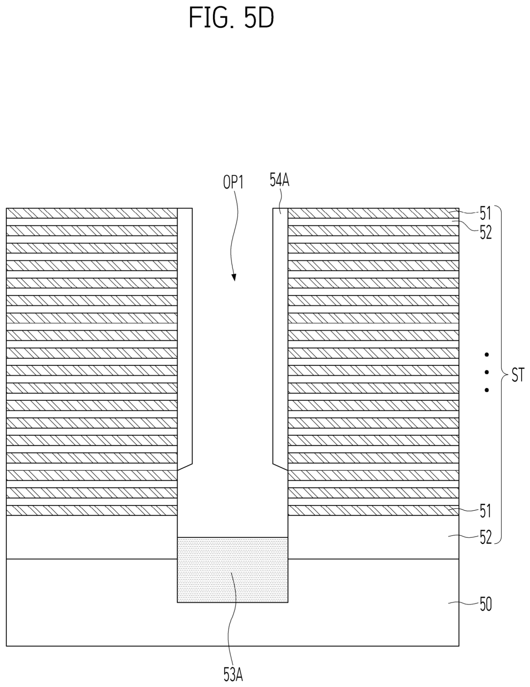

Referring to FIG. 5D, the sacrificial pattern 53 may be etched using the barrier pattern 54A as an etching barrier. As an example, the sacrificial pattern 53 is selectively etched by a wet etching method. An upper surface of the etched sacrificial pattern 53A may be disposed between an upper surface and a lower surface of the lowermost second material layer. Through this, the stack ST may be exposed between the sacrificial pattern 53A and the barrier pattern 54A. The first material layers corresponding to the source select lines among the first material layers 51 may be exposed.

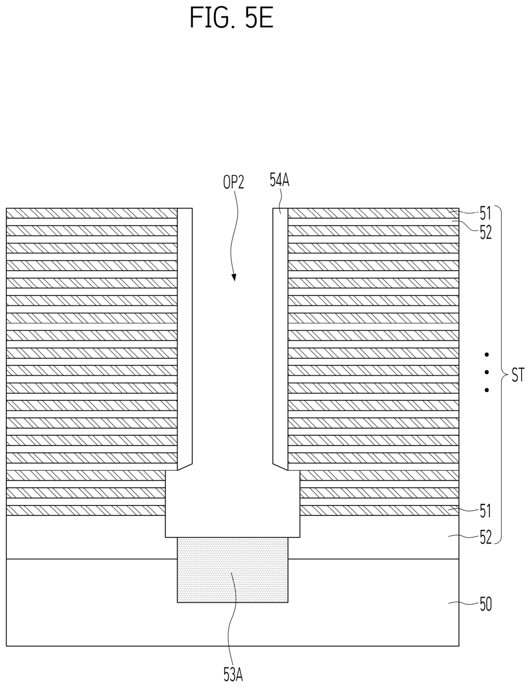

Referring to FIG. 5E, a second opening OP2 may be formed by etching the stack ST exposed between the sacrificial pattern 53A and the barrier pattern 54A. As an example, after the first material layers 51 are selectively etched, the second material layers 52 may be selectively etched. Alternatively, after the second material layers 52 are selectively etched, the first material layers 51 may be selectively etched. Alternatively, the first and second material layers 51 and 52 may be etched simultaneously.

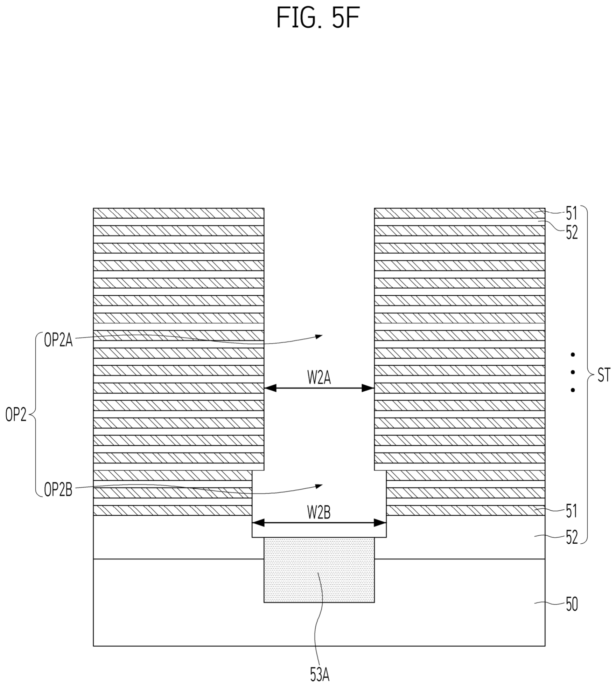

Referring to FIG. 5F, the barrier pattern 54A may be removed. The second opening OP2 may include a first portion OP2A having a first width W2A and a second portion OP2B having a second width W2B greater than the first width W2A. The second portion OP2B may be disposed between the sacrificial pattern 53A and the first portion OP2A. Here, the first portion OP2A may be an upper portion, and the second portion OP2B may be a lower portion. Subsequently, a channel structure may be formed in the second opening OP2. The channel structure may include a channel layer, and may further include a memory layer and/or an insulating core.

According to the method described above, the first opening OP1 may be partially expanded using the sacrificial pattern 53A and the barrier pattern 54A. The second opening OP2 including the first portion OP2A and the second portion OP2B having a greater width than the first portion OP2A may be formed.

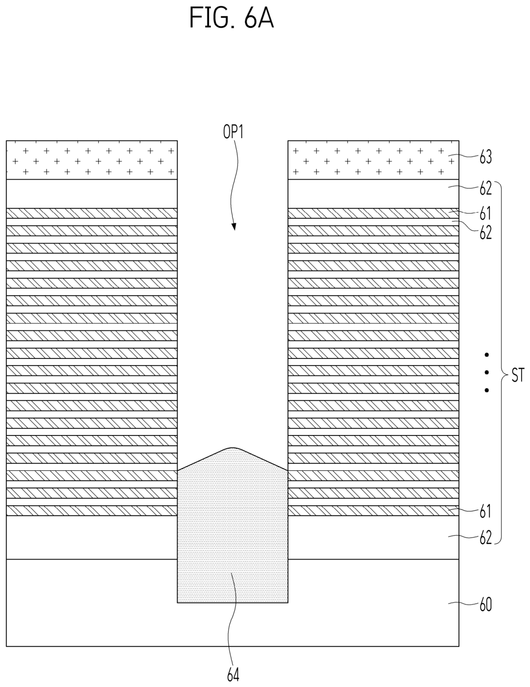

FIGS. 6A to 6H are diagrams for describing a method of manufacturing a semiconductor device in accordance with an embodiment of the present disclosure. Hereinafter, content overlapping with previously described content may be omitted.

Referring to FIG. 6A, a stack ST including first material layers 61 and second material layers 62 that are alternately stacked may be formed on a substrate 60. The first material layers 61 may be used to form gate lines, and the second material layers 62 may be used to insulate the stacked gate lines from each other. The first material layers 61 may each include a material having a high etching selectivity with respect to the second material layers 62. The first material layers 61 may each include a sacrificial material such as nitride or a conductive material such as polysilicon or metal. The second material layers 62 may each include an insulating material such as oxide. The uppermost second material layer and the lowermost second material layer of the second material layers 62 may have a greater thickness than the remaining second material layers. As an example, the uppermost second material layer may be a hard mask oxide layer.

Subsequently, a hard mask pattern 63 may be formed on the stack ST. The hard mask pattern 63 may include nitride. Subsequently, a first opening OP1 extending through the stack ST and exposing the substrate 60 may be formed. As an example, the first opening OP1 may be formed by etching the stack ST using the hard mask pattern 63 as an etching barrier. The first opening OP1 may have a uniform width or have different widths depending on levels. As an example, the first opening OP1 may have a cross section with a tapered shape.

Subsequently, a sacrificial pattern may be formed in the first opening OP1. As an example, an epitaxial pattern 64 may be formed by growing a silicon layer from the substrate 60 exposed through the first opening OP1. An upper surface of the epitaxial pattern 64 may include a curved surface. As an example, the epitaxial pattern 64 may be formed at a height at which it covers the first material layers 61 corresponding to source select lines.

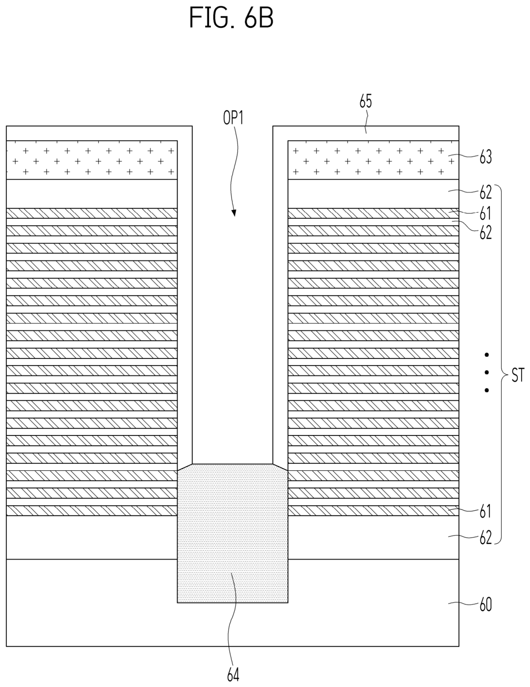

Referring to FIG. 6B, a barrier pattern 65 may be formed in the first opening OP1. The barrier pattern 65 may be formed along a surface of the stack ST exposed through the first opening OP1 and a surface of the hard mask pattern 63. The upper surface of the epitaxial pattern 64 may be exposed by the barrier pattern 65. As an example, the barrier pattern 65 may include metal nitride such as TiN.

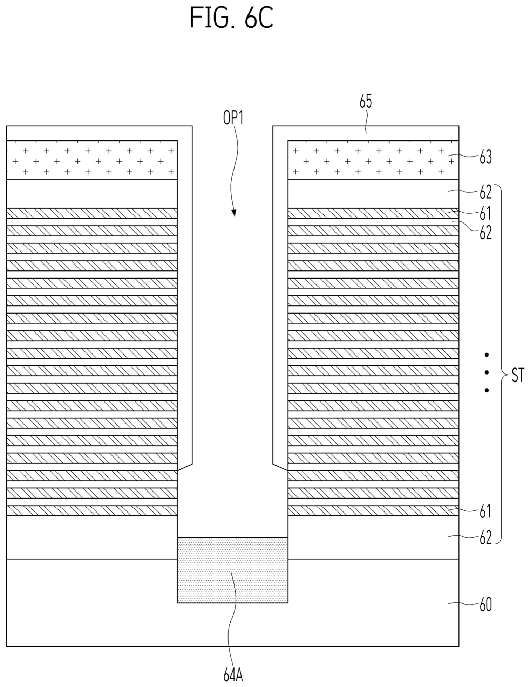

Referring to FIG. 6C, the epitaxial pattern 64 may be etched using the barrier pattern 65 as an etching barrier. As an example, the epitaxial pattern 64 is selectively etched by a wet etching method. An upper surface of the etched epitaxial pattern 64A may be disposed between an upper surface and a lower surface of the lowermost second material layer. Through this, the stack ST may be exposed between the epitaxial pattern 64A and the barrier pattern 65. The first material layers corresponding to the source select lines among the first material layers 61 may be exposed.

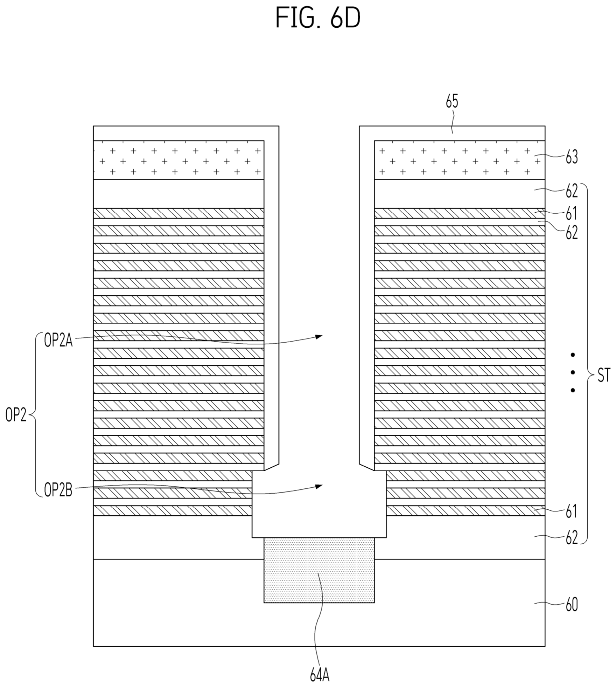

Referring to FIG. 6D, a second opening OP2 may be formed by etching the stack ST exposed between the epitaxial pattern 64A and the barrier pattern 65. The second opening OP2 may include a first portion OP2A and a second portion OP2B having a greater width than the first portion OP2A. Here, the first portion OP2A may be an upper portion, and the second portion OP2B may be a lower portion.

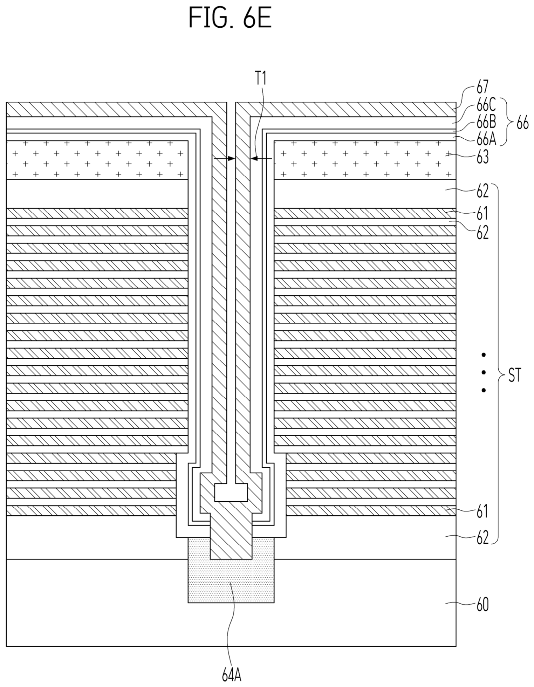

Referring to FIG. 6E, the barrier pattern 65 may be removed. Subsequently, a memory layer 66 may be formed in the second opening OP2. The memory layer 66 may include a blocking layer 66A, a data storage layer 66B, and a tunneling layer 66C. Subsequently, the memory layer 66 may be etched so that the epitaxial pattern 64A is exposed. A portion of the memory layer 66 formed on the upper surface of the epitaxial pattern 64A may be etched. In a process of etching the memory layer 66, the epitaxial pattern 64A may be partially etched.

Subsequently, a preliminary channel layer 67 may be formed in the second opening OP2. The preliminary channel layer 67 connected to the epitaxial pattern 64A may be formed on the memory layer 66. As an example, an amorphous silicon layer may be formed, and a polysilicon layer may be formed by crystallizing the amorphous silicon layer through a heat treatment process. Through this, the preliminary channel layer 67 including polysilicon may be formed. As a thickness of the preliminary channel layer 67 increases, grains may be grown in a great size, and thus, the preliminary channel layer 67 may be formed at a first thickness T1 greater than a target thickness.

When a thickness of the preliminary channel layer 67 is great, a lower portion of the second opening OP2 may be closed in a process of depositing the preliminary channel layer 67. When the preliminary channel layer 67 is deposited in the first opening OP1 having a tapered shape, a lower width of the first opening OP1 is small, and it is thus difficult to deposit the preliminary channel layer 67 at a sufficient thickness. Accordingly, by increasing the lower width of the first opening OP1 to form the second opening OP2, the embodiments enable formation of the preliminary channel layer 67 at the first thickness T1 enough to have a great grain size.

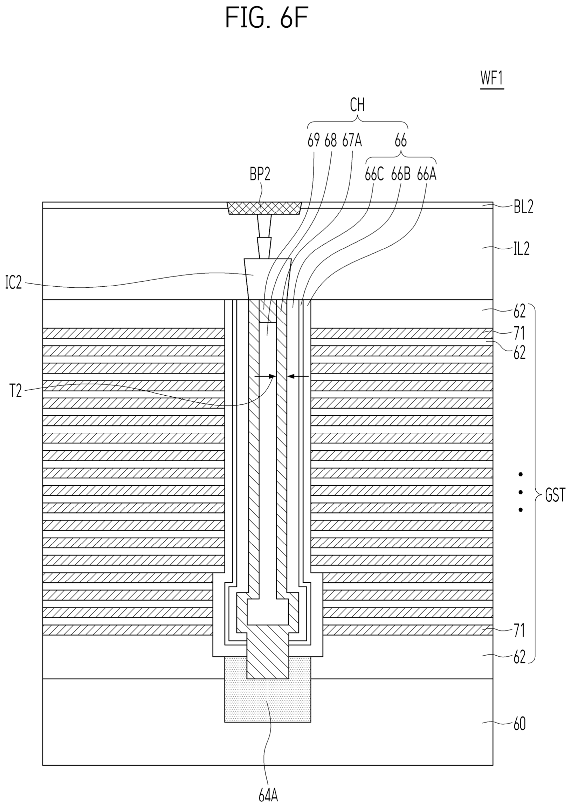

Referring to FIG. 6F, a channel layer 67A having a second thickness T2 smaller than the first thickness T1 may be formed by etching the preliminary channel layer 67. Through this, the channel layer 67A having a target thickness may be formed. The channel layer 67A may be connected to the epitaxial pattern 64A. Subsequently, an insulating core 68 and a capping layer 69 may be formed. As an example, the insulating core 68 may be formed by forming (for example, depositing) an insulating layer on the channel layer 67A and etching the insulating layer by a cleaning process, and the capping layer 69 may be then formed. The insulating core 68 may include oxide, and the capping layer 69 may include polysilicon. Through this, a channel structure CH including the memory layer 66, the channel layer 67A, the insulating core 68, and the capping layer 69 may be formed. For reference, a configuration of the channel structure CH may be changed, and the memory layer 66 may be omitted and the channel layer 67A may be formed.

Subsequently, the first material layers 61 may be replaced with third material layers 71. As an example, recess regions may be formed by removing the first material layers 61, and the third material layers 71 may be formed in the recess regions. The third material layers 71 are used to form gate lines, and may each include metal such as tungsten (W) or molybdenum (Mo). Through this, a gate structure GST including the second material layers 62 and the third material layers 71 that are alternately stacked may be formed.

For reference, a case where the channel structure CH includes the memory layer 66 has been described in the above-described embodiment, but the memory layer 66 may be omitted in a process of forming the channel structure CH. In such a case, the third material layers 71 may be formed after the memory layers are formed in the recess regions. In addition, when the first material layers 61 each include the conductive material, the process of replacing the first material layers 61 with the third material layers 71 may be omitted. In such a case, the first material layers 61 may be used as the gate lines, and the stack ST may be used as the gate structure GST.

Subsequently, the hard mask pattern 63 may be removed, and the second material layer 62 may be additionally formed. Through this, the channel structure CH may be covered. Subsequently, a second interlayer insulating layer IL2 and a second interconnection structure IC2 may be formed. The second interconnection structure IC2 may be connected to the channel structure CH or the like. Subsequently, a second bonding layer BL2 and a second bonding pad BP2 may be formed. The second bonding pad BP2 may be connected to the second interconnection structure IC2. Through this, a first wafer WF1 including a memory cell array may be formed.

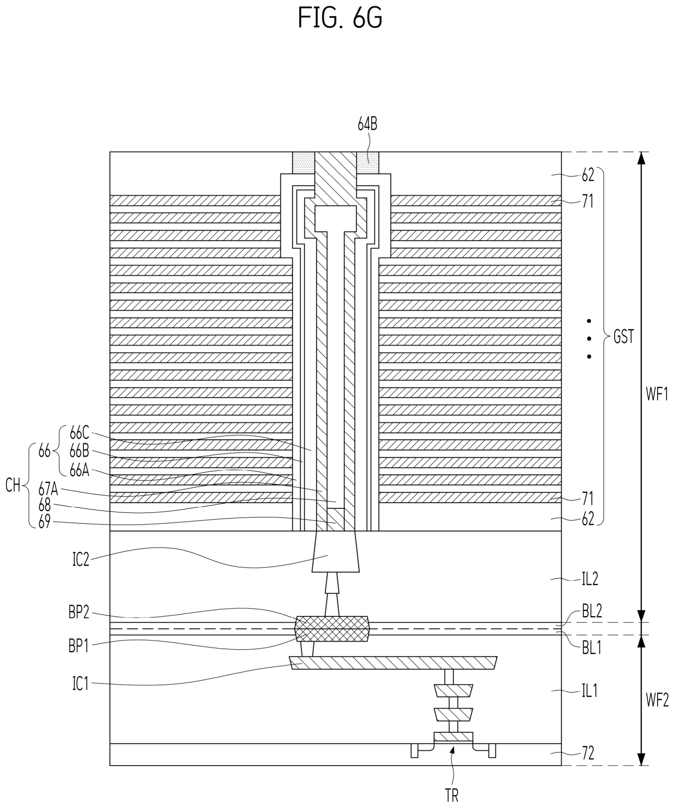

Referring to FIG. 6G, a second wafer WF2 including a peripheral circuit may be formed. The second wafer WF2 may include a substrate 72, a transistor TR, a first interlayer insulating layer IL1, a first interconnection structure IC1, a first bonding layer BL1, and a first bonding pad BP1.

Subsequently, the first wafer WF1 and the second wafer WF2 may be bonded to each other. The first bonding layer BL1 and the second bonding layer BL2 may be bonded to each other, and the first bonding pad BP1 and the second bonding pad BP2 may be electrically connected to each other. As an example, the first wafer WF1 may be upside down and bonded to the second wafer WF2, and a back surface of the substrate 60 of the first wafer WF1 may be exposed.

Subsequently, the epitaxial pattern 64B may be exposed by removing the substrate 60. As an example, the substrate 60 may be planarized so that a surface of the uppermost second material layer 62 is exposed. A planarization process may be performed by a chemical mechanical polish (CMP) method. In a process of planarizing the substrate 60, the epitaxial pattern 64B and/or the channel layer 67A may be partially etched. As an example, the channel layer 67A and the epitaxial pattern 64B may be exposed through the planarization process, and the epitaxial pattern 64B may have a spacer shape surrounding sidewalls of the channel layer 67A. As an example, through the planarization process, the epitaxial pattern 64B may be exposed and the channel layer 67A might not be exposed. In such a case, the epitaxial pattern 64B may surround sidewalls and an upper surface of the channel layer 67A, and may have a U-shaped cross section. Subsequently, the channel layer 67A may be doped with impurities. Through this, a junction of a source select transistor may be formed.

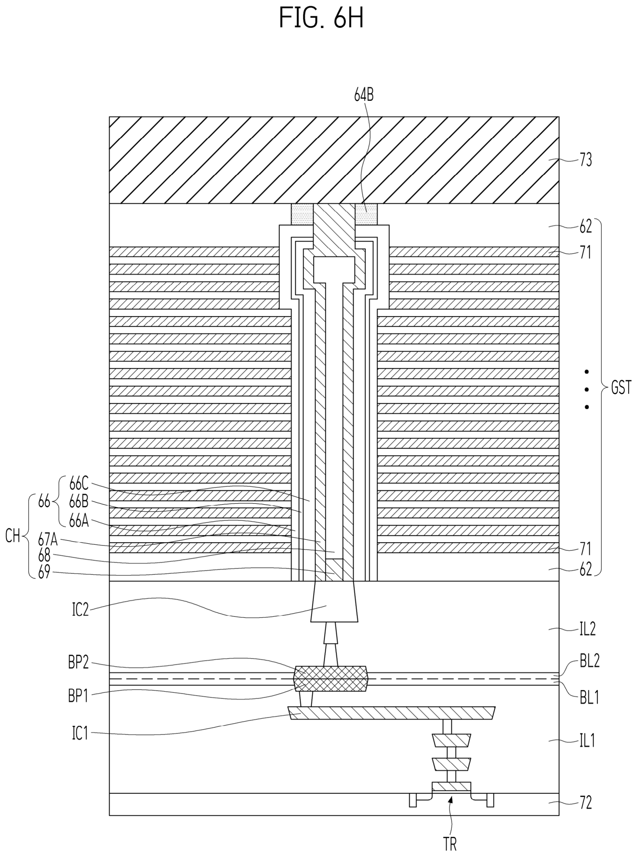

Referring to FIG. 6H, a source layer 73 may be formed over the gate structure GST. The source layer 73 may be disposed on a back surface of the gate structure GST. The source layer 73 may be directly connected to the channel layer 67A and the epitaxial pattern 64B or be connected to the channel layer 67A through the epitaxial pattern 64B. The source layer 73 may include a conductive material such as polysilicon or metal.

According to the method described above, the second opening OP2 including the first portion OP2A and the second portion OP2B having the greater width than the first portion OP2A may be formed using the epitaxial pattern 64B and the barrier pattern 65. The preliminary channel layer 67 having a sufficient thickness may be formed in the second opening OP2, and the channel layer 67A having a great grain size may be formed. In addition, the first wafer WF1 and the second wafer WF2 are bonded to each other, and the disclosed embodiments may thereby increase the degree of integration of the semiconductor device.

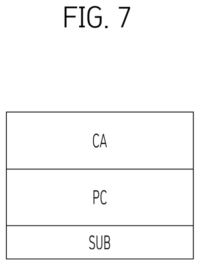

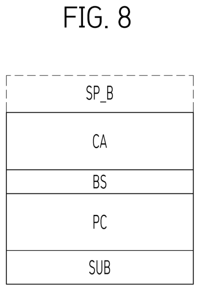

The structures and the methods in accordance with the above-described embodiments may be applied to semiconductor devices having various structures. FIGS. 7 and 8 illustrate schematic configurations of semiconductor devices to which the above-described embodiments are applicable.

FIG. 7 is a configuration diagram of a semiconductor device in accordance with an embodiment.

Referring to FIG. 7, the semiconductor device may include a substrate SUB, a peripheral circuit PC, and a memory cell array CA. Here, the peripheral circuit PC and the memory cell array CA may be formed on the same substrate.

The substrate SUB may include a semiconductor material. As an example, the semiconductor material may include at least one of a group IV semiconductor, a group III-V compound semiconductor, and a group II-VI compound semiconductor. Here, the group IV semiconductor may include single crystal silicon (Si), polycrystalline silicon, germanium (Ge), or silicon germanium (SiGe). The group III-V compound semiconductor may include gallium arsenide (GaAs), gallium nitride (GaN), gallium phosphide (GaP), gallium arsenide phosphide (GaAsP), gallium indium arsenide phosphide (GaInAsP), aluminum arsenide (AlAs), aluminum gallium (AlGa), indium phosphide (InP), indium antimonide (InSb), or indium gallium arsenide (InGaAs). The group II-VI compound semiconductor may include zinc sulfide (ZnS), zinc oxide (ZnO), or cadmium sulfide (CdS).

The substrate SUB may include a dielectric layer. The substrate SUB may be a silicon-on-insulator (SOI) substrate, a germanium-on-insulator (GeOI) substrate, or a glass substrate. The substrate SUB may include an organic material. As an example, the substrate SUB may include graphene.

The substrate SUB may be a bulk wafer or an epitaxial layer grown by a selective epitaxial growth (SEG) method. The substrate SUB may be a layer formed by a metal induced lateral crystallization (MILC) method, and may partially include metal. The substrate SUB may have a single crystalline, polycrystalline, or amorphous state. The substrate SUB may include group II, group III, group IV, group V, or group VI impurities. As an example, the substrate SUB may include an n-well region doped with n-type impurities and/or a p-well region doped with p-type impurities.

The peripheral circuit PC may be disposed between the substrate SUB and the memory cell array CA. The peripheral circuit PC may include a row decoder, a column decoder, a page buffer, a logic circuit, a control circuit, a sense amplifier, an input/output circuit, and the like. As an example, the peripheral circuit PC may include an N-channel metal oxide semiconductor (NMOS) transistor, a P-channel metal oxide semiconductor (PMOS) transistor, a resistor, a capacitor, and the like. The peripheral circuit PC may further include an interconnection structure. The interconnection structure may be used as a path for transmitting an operation voltage, and may include a contact plug, a wiring line, and the like.

The memory cell array CA may include memory cells. As an example, the memory cell array CA may include memory strings connected between a source line and a bit line, and each memory string may include stacked memory cells. As an example, the memory cell array CA may include memory cells connected between a word line and the bit line. The memory cell array CA may further include an interconnection structure.

FIG. 8 is a configuration diagram of a semiconductor device in accordance with an embodiment.

Referring to FIG. 8, the semiconductor device may include a substrate SUB, a peripheral circuit PC, a bonding structure BS, and a memory cell array CA. Here, the peripheral circuit PC and the memory cell array CA may be formed on separate substrates, respectively, and then bonded to each other through the bonding structure BS. The semiconductor device may further include a support base SP_B.

The substrate SUB may be used as a support in a process of forming the peripheral circuit PC. The support base SP_B may be used as a support in a process of forming the memory cell array CA. As an example, a first wafer including the memory cell array CA and a second wafer including the peripheral circuit PC may be manufactured, respectively, and then electrically connected to each other by the bonding structure BS. After the first wafer and the second wafer are bonded to each other, the support base SP_B of the first wafer may be at least partially removed. The support base SP_B may be completely removed or may partially remain on the memory cell array CA.

The support base SP_B may be a semiconductor substrate, an insulating substrate, a silicon-on-insulator (SOI) substrate, a germanium-on-insulator (GeOI) substrate, or the like. The support base SP_B may be a bulk wafer, an epitaxial layer grown by a selective epitaxial growth (SEG) method, or a layer formed by a metal induced lateral crystallization (MILC) method. The support base SP_B may have a single crystalline, polycrystalline, or amorphous state. The support base SP_B may include group II, group III, group IV, group V, or group VI impurities.

The bonding structure BS may be used to connect the memory cell array CA and the peripheral circuit PC to each other. As an example, the bonding structure BS may bond the memory cell array CA and the peripheral circuit PC to each other by a wafer-on-wafer bonding method, a chip-on-wafer bonding method, a chip-on-chip bonding method, or the like. The bonding structure BS may include a bonding pad, a bonding layer, a bonding interface, and the like. The bonding pad may include metal such as copper or aluminum and/or alloys thereof. The bonding interface may include a nonmetal-nonmetal interface, a metal-metal interface, or the like. The memory cell array CA and the peripheral circuit PC may be electrically connected to each other by the bonding structure BS.

For reference, it is also possible for interconnection structures included in the memory cell array CA and/or the peripheral circuit PC to be directly connected to each other without a bonding pad. As an example, a bonding layer included in the memory cell array CA and a bonding layer included in the peripheral circuit PC may be bonded to each other to form a bonding interface, and an interconnection structure included in the memory cell array CA and an interconnection structure included the peripheral circuit PC may be directly connected to each other. Through this, contact plugs, wiring lines, and the like, formed on different wafers may be electrically connected to each other without a separate bonding pad.

Other configurations may be the same as or similar to those described above with reference to FIG. 7.

Meanwhile, it is also possible for the semiconductor device to have a structure in which embodiments described above with reference to FIGS. 7 and 8 combine with each other or have a partially modified structure. In embodiments described with reference to FIGS. 7 and 8, locations of the memory cell array CA and the peripheral circuit PC may be changed. At least one memory cell array CA and/or at least one peripheral circuit PC may be additionally bonded in embodiments described with reference to FIGS. 7 and 8. As an example, a portion of the peripheral circuit PC may be disposed in the memory cell array CA.

Although embodiments according to the technical idea of the present disclosure have been described above with reference to the accompanying drawings, this is only for explaining the embodiments according to the concept of the present disclosure, and the present disclosure is not limited to the above embodiments. Various types of substitutions, modifications, changes, and combinations for the embodiments may be made by those skilled in the art, to which the present disclosure pertains, without departing from the technical idea of the present disclosure defined in the following claims, and it should be construed that these substitutions, modifications, changes, and combinations belong to the scope of the present disclosure.

## Claims

1. A semiconductor device comprising:
a gate structure including alternately stacked conductive layers and insulating layers;
a source layer disposed to face a surface of the gate structure;
a channel structure extending through the gate structure and including a first portion and a second portion, the first portion having a first width, the second portion having a second width greater than the first width; and
an epitaxial pattern disposed between at least a portion of the channel structure and the source layer and connected to the second portion of the channel structure.

2. The semiconductor device of claim **1,** wherein the channel structure further includes a third portion having a third width less than the second width and connected to the source layer.

3. The semiconductor device of claim 2, wherein the epitaxial pattern has a spacer shape surrounding sidewalls of the third portion.

4. The semiconductor device of claim 2, wherein the epitaxial pattern has a U-shaped cross section surrounding the third portion.

5. The semiconductor device of claim **1,** wherein the epitaxial pattern has a fourth width less than the second width.

6. The semiconductor device of claim 1, wherein the channel structure comprises:
an insulating core;
a memory layer surrounding the insulating core; and
a channel layer including a body portion disposed between the insulating core and the memory layer and a protrusion portion protruding from the body portion and penetrating through the memory layer.

7. The semiconductor device of claim 6, wherein the protrusion portion penetrates through the epitaxial pattern and is connected to the source layer.

8. The semiconductor device of claim 6, wherein the epitaxial pattern has a U shape surrounding the protrusion portion, and the channel layer is connected to the source layer through the epitaxial pattern.

9. The semiconductor device of claim **1,** wherein the epitaxial pattern is in contact with a flat upper surface of the channel structure, and the channel structure is connected to the source layer through the epitaxial pattern.

10. A semiconductor device comprising:
a gate structure including alternately stacked conductive layers and insulating layers;
a source layer disposed over the gate structure;
an insulating core extending through the gate structure and including a first region and a second region, the first region having a first width, the second region having a second width greater than the first width;
a memory layer surrounding the insulating core;
a channel layer including a body portion and a protrusion portion, the body portion disposed between the insulating core and the memory layer, the protrusion portion penetrating through the memory layer and connected to the source layer; and
an epitaxial pattern disposed between the source layer and the memory layer and surrounding sidewalls of the protrusion portion.

11. The semiconductor device of claim 10, wherein the second region is disposed closer to the source layer than the first region.

12. The semiconductor device of claim 10, wherein an upper surface of the memory layer is disposed at a lower level than an upper surface of the channel layer.

13. The semiconductor device of claim 10, wherein an upper surface of the epitaxial pattern is coplanar with an upper surface of the channel layer.

14. The semiconductor device of claim 10, wherein a lower surface of the epitaxial pattern is disposed at a higher level than an upper surface of an uppermost conductive layer of the conductive layers.

15. The semiconductor device of claim 10, wherein an upper surface of the memory layer is disposed at a higher level than an upper surface of an uppermost conductive layer of the conductive layers.
